# EUROPEAN PATENT SPECIFICATION

(11) **EP 4 355 040 B1**
(45) Date of publication and mention of the grant of the patent: **30.09.2026**
(21) Application number: 21951255.5
(22) Date of filing: 28.07.2021
(51) Int. Cl.: H05K 3/3452, H05K 3/00, H10W 72/20, H05K 1/181, H05K 3/341, H10W 74/15

(54) **CIRCUIT SUBSTRATE, RELATED CIRCUIT ASSEMBLY, AND ELECTRONIC DEVICE**
SCHALTUNGSSUBSTRAT, ZUGEHÖRIGE SCHALTUNGSANORDNUNG UND ELEKTRONISCHE VORRICHTUNG
SUBSTRAT DE CIRCUIT, ENSEMBLE CIRCUIT ASSOCIÉ ET DISPOSITIF ÉLECTRONIQUE

(43) Date of publication of application: 17.04.2024
(73) Proprietor: Huawei Technologies Co., Ltd., Shenzhen, Guangdong 518129 (CN)
(72) Inventor: ZHENG, Guisong, Shenzhen, Guangdong 518129 (CN); CHEN, Zunmiao, Shenzhen, Guangdong 518129 (CN)
(74) Representative: Gill Jennings & Every LLP
(86) International application number: PCT/CN2021/109040
(87) International publication number: WO 2023/004641

(56) References cited:
- CN-A- 102 088 823
- CN-A- 104 810 338
- CN-A- 112 055 461
- DE-A1- 102010 036 191
- US-A1- 2004 113 285
- US-A1- 2005 023 683
- US-B1- 6 268 568

## Description

### TECHNICAL FIELD

The present disclosure generally relates to chip packaging, and specifically, to a circuit substrate for carrying an electronic device, a manufacturing method, a related circuit assembly, and electronic equipment.

### BACKGROUND

A solder mask (Solder Mask, SM) is a thin layer of polymer used on a circuit substrate such as an Ajinomoto build-up film (Ajinomoto Build-up Film, ABF) carrier board, a bismaleimide triazine (Bismaleimide Triazine, BT) resin carrier board, or a printed circuit board (Printed Circuit Board, PCB), to prevent solder point bridging. The solder mask covers a trace on the circuit substrate to prevent the trace from being oxidized. The solder mask may be made of four common types of materials: top-surface and bottom-surface films, an epoxy liquid solder mask, a liquid photoimageable solder mask, and a dry-film photoimageable solder mask. Those materials usually have a same function, but costs of some materials may be higher. Several main materials for manufacturing the solder mask are thermally cured to cure a structure of the solder mask and form a protective barrier.

A key function of the solder mask is to prevent a pad and the trace on the circuit substrate from being oxidized and corroded. In addition, as mentioned above, the solder mask can also prevent bridging. The solder point bridging is an accidental connection of solder points on the circuit substrate, and may cause damage and a short circuit of the circuit substrate. The solder mask serves as a dam between the pad and another conductive part of the circuit substrate, to form additional insulation of an assembly on the circuit substrate. US 2004/113285 A1 discloses microelectronic packaging and, more particularly to reducing fatigue and crack propagation in the electrical interconnections of ball grid array packaging. DE 102010036191 A1 discloses a method for producing a printed circuit board and the printed circuit board produced thereby. US 2005/023683 A1 discloses electronic packaging technology and, more particularly, to semiconductor packages having improved ball land structures.

### SUMMARY

The present disclosure relates to a technical solution of a circuit substrate, and specifically provides a circuit substrate for carrying an electronic device, and a circuit assembly and electronic equipment that are related to a manufacturing method. The invention is defined in the appended claims.

According to a first aspect of the present disclosure, a circuit substrate is provided. The circuit substrate includes: a body, including a surface for carrying an electronic device; a plurality of pads, distributed on the surface; and a solder mask, distributed to cover the surface and at least a part of an edge of the pad, and including a plurality of openings. The plurality of openings are suitable for exposing the pad to allow the pad to be electrically connected to a pin of the electronic device. Each opening includes at least one notch part. The notch part is formed to have a predetermined angle relative to a center of the opening to expose a part that is of the edge of the pad and that is within the predetermined angle. A notch part of at least a part of the plurality of openings is arranged toward a predetermined point. The notch part is disposed on the opening of the solder mask, so that when solder is added, the solder mask does not undercut a weak point, and the solder directly covers the edge of the pad and is combined with the body. In this case, even if a part of the solder mask cracks, the solder does not enter through a crack, so that there is no risk that the electronic device fails. Therefore, reliability of a package body is improved. In addition, an underfill material may be made of any suitable material, and a soft underfill material does not need to be used to prevent the solder mask from cracking, so that an electrical connection between a pin of a chip and the pad is not affected, and the reliability of the package body is further improved. Further, the foregoing distribution manner can effectively prevent the pad from falling off and achieve many of the foregoing benefits without additional costs.

In some implementations, the notch part is distributed on the opening in a direction of a geometric center of the electronic device. Statistics show that cracking of the solder mask mostly occurs at a centripetal position of an edge of the opening. In the foregoing manner, a problem of cracking of the solder mask and a failure of the electronic device caused by the cracking of the solder mask can be effectively avoided, so that stability can be further improved.

In some implementations, the pad is formed to enable a radius that is of the pad and that corresponds to the notch part to be greater than or equal to a radius of another part of the opening other than the notch part. In this manner, a soldering area between the solder and the pad basically remains unchanged, so that stability of the package body can be improved without changing electrical performance of the package body.

In some implementations, the electronic device includes a semiconductor chip, a semiconductor package body, or an adapter board. In this case, the invention idea of the present disclosure can be used to not only improve performance of the package body, but also improve the stability when the package body or the adapter board is soldered to a printed circuit board.

According to a second aspect of the present disclosure, a circuit assembly is provided. The circuit assembly includes an electronic device and the circuit substrate in the first aspect. The foregoing circuit substrate is used, so that reliability of the circuit assembly such as a semiconductor package body can be improved.

In some implementations, the electronic device is coupled to the circuit substrate by using a flip chip technology. In this way, stability of the circuit assembly manufactured by using a common flip chip technology is improved.

In some implementations, the circuit assembly further includes at least one of an underfill adhesive and a solid-state molding material that are filled between the electronic device and the circuit substrate. In other words, an underfill material may be made of any suitable material, so that an electrical connection between a pin of a chip and a pad is not affected, and reliability of the package body is further improved.

According to a third aspect of the present disclosure, a method for manufacturing a circuit substrate for carrying an electronic device is provided. The method includes: coating or printing a solder mask on a body of the circuit substrate on which a pad has been distributed; exposing the solder mask, and shielding, by using a mask, a part that is of the solder mask and that is aligned with the pad to prevent the part from being exposed, where the mask includes a mask body and at least one radial protruding part that protrudes from the mask body, and the radial protruding part is distributed in a predetermined angle range relative to a center of the mask body; and the radial protruding part of at least a part of the mask is arranged toward a predetermined point; and developing the solder mask by using a developing liquid, to remove an unexposed part of the solder mask, where the unexposed part includes an opening including a notch part, the notch part corresponds to the radial protruding part. In this manner, a circuit substrate with reliable performance can be produced.

In some implementations, the method further includes: removing an edge that is of the pad and that is exposed to the notch part to enable a radius that is of the pad and that corresponds to the notch part to be equal to a radius of the opening. When the circuit substrate produced in this manner is mounted, a soldering area between solder and the pad can remain basically unchanged, so that stability of a package body can be improved without changing electrical performance of the package body.

According to a fourth aspect of the present disclosure, electronic equipment is provided. The electronic equipment includes the circuit substrate and the electronic device that are limited in the first aspect, and the electronic device is carried on the surface of the body of the circuit substrate. In this manner, reliability of the electronic equipment can be improved.

Other features of the present disclosure will be easily understood by the following descriptions.

### BRIEF DESCRIPTION OF DRAWINGS

The foregoing and other objects, features, and advantages of embodiments of the present disclosure become easily understood by reading the following detailed descriptions with reference to the accompanying drawings. In the accompanying drawings, several embodiments of the present disclosure are shown by way of example and not limitation.
FIG. 1 is a simplified schematic top view of a circuit substrate according to an embodiment of the present disclosure;
FIG. 2 is a simplified schematic side view of a circuit substrate according to an embodiment of the present disclosure;
FIG. 3 is a simplified schematic side view of a package body according to an embodiment of the present disclosure;
FIG. 4A shows an example of an opening of a solder mask and a pad according to an embodiment of the present disclosure;
FIG. 4B shows another example of an opening of a solder mask and a pad according to an embodiment of the present disclosure;
FIG. 4C is a partial schematic top view in which an opening of a solder mask and a pad overlap according to an embodiment of the present disclosure;
FIG. 5 is a simplified schematic top view of a circuit substrate according to an embodiment of the present disclosure, where it is shown that an electronic device is not located at a central position of the circuit substrate;
FIG. 6 is a simplified schematic top view of a circuit substrate according to an embodiment of the present disclosure, where it is shown that the circuit substrate can carry two electronic devices;
FIG. 7 is a simplified schematic top view of a circuit substrate according to an embodiment of the present disclosure, where it is shown that electronic devices carried by the circuit substrate are rectangular; and
FIG. 8 is a schematic flowchart of a method for manufacturing a circuit substrate for carrying an electronic device according to an embodiment of the present disclosure.

Throughout all the accompanying drawings, same or similar reference numerals represent same or similar assemblies.

### DESCRIPTION OF EMBODIMENTS

The principle of the present disclosure will be described below with reference to several example embodiments shown in the accompanying drawings. It should be understood that these specific embodiments are described only to enable a person skilled in the art to better understand and implement the present disclosure.

As used in this specification, a term "including" and similar terms thereof should be understood as open inclusion, in other words, "including but not limited to". A term "based on" should be understood as "at least partially based on". A term "an embodiment" or "this embodiment" should be understood as "at least one embodiment". Terms "first", "second", and the like may refer to different or same objects, which are used only to distinguish the objects referred to, and do not imply a specific spatial sequence, a time sequence, an importance sequence, or the like of the objects referred to. In some embodiments, a value, a process, a selected item, a determined item, equipment, an apparatus, a means, a component, an assembly, and the like are described as "best", "lowest", "highest", "smallest", "largest", and the like. It should be understood that such descriptions are intended to indicate that a selection may be made among many available functional selections, and such a selection does not need to be better, lower, higher, smaller, larger, or otherwise preferred in other aspects or all aspects than other selections. As used in this specification, a term "determining" may cover various actions. For example, "determining" may include operating, calculating, processing, exporting, investigating, searching (for example, searching in a table, a database, or another data structure), finding out, and the like. In addition, "determining" may include receiving (for example, receiving information), accessing (for example, accessing data in a memory), and the like. Further, "determining" may include parsing, selecting, choosing, establishing, and the like.

A term "circuit" used in this specification means one or more of the following: (a) an implementation of only a hardware circuit (such as an implementation of only an analog and/or digital circuit); (b) a combination of a hardware circuit and software, such as (if applicable): (i) a combination of an analog and/or digital hardware circuit and software/firmware, and (ii) any part of a hardware processor and software (including a digital signal processor, software, and a memory that work together to enable an apparatus, such as a communication equipment or another electronic equipment, to perform various functions); and (c) a hardware circuit and/or a processor, such as a microprocessor or a part of the microprocessor, which requires software (such as firmware) to be used for an operation, but may not have software when software is not required for an operation. The definition of the circuit is applicable to all scenarios in which the term is used in this application (including the claims). In another example, the term "circuit" used herein alternatively covers only a hardware circuit or a processor (or a plurality of processors), a part of the hardware circuit or the processor, or an implementation of accompanying software or firmware. For example, if applicable to a particular claim element, the term "circuit" further covers a baseband integrated circuit or a processor integrated circuit, or a similar integrated circuit in a network device, a terminal device, or another device.

As mentioned above, a solder mask is usually used as an outermost circuit protective layer of a circuit substrate, to avoid external physical or chemical damage to a metal circuit, and can isolate different metal circuits to prevent a short circuit caused by solder in a reflow process. The solder mask is widely used, and is usually used in a process of chip packaging, and a process of soldering a chip package body and a circuit adapter board to a printed circuit board. Currently, a pad and a trace on a circuit substrate are basically manufactured by using copper foil. Usually, a solder mask is used to cover most of the pads and the traces during designing or manufacturing the circuit substrate, and a pad that needs to be contacted or soldered is exposed. In some products, especially in a product manufactured by using a flip chip (Flip Chip, FC) technology, a solder mask using a solder mask defined (Solder Mask Defined, SMD) design may crack. The SMD design is to cover a pad with a large area by using a solder mask, and then expose the pad at an opening of the solder mask (in other words, a position that is not covered by the solder mask) to provide an electrical connection for a pin of an electronic device. In other words, in the SMD design, a size of the opening of the solder mask is less than a size of the pad, so that an edge of the pad is covered by the solder mask and only a part of the inside of the pad is exposed. The solder mask cracks, and consequently, the solder may enter between the solder mask and the circuit substrate or the metal line through a crack. As a result, a short circuit occurs on the metal line. Even if no short circuit occurs, when the solder enters the solder mask through the crack, a distance between the metal lines or the pads is reduced. As a result, metal migration occurs in a use process of a product, and electricity leakage is caused. Consequently, the product finally fails.

At present, how to prevent the solder mask from cracking becomes one of key factors in quality and reliability control of some products, especially a flip chip product. How to improve a problem of cracking of the solder mask is also an urgent need to improve product quality and reliability. In traditional solutions, there are several manners to prevent the solder mask from cracking. An important reason for cracking of the solder mask is stress on the solder mask caused by deformation of the electronic device and/or the circuit substrate due to heat. One solution is to select a soft underfill (Underfill, UF) adhesive to reduce a risk that the solder mask cracks due to the stress. This solution is a type of underfill performed on a chip in a ball grid array (Ball Grid Array, BGA) package mode by using a chemical adhesive, and a gap at the bottom of a BGA package and between the chip and a circuit substrate is filled in a heating curing form, to achieve a hardening objective. In this way, anti-drop performance between the chip in the BGA package mode and the circuit substrate is improved.

The soft underfill adhesive is used, so that stress borne by the solder mask at a high temperature can be relieved, and the problem of cracking of the solder mask is relieved. However, this solution brings another problem. Because the used underfill adhesive is excessively soft, protection strength for the chip, the circuit substrate, and an electrical connection between the chip and the circuit substrate is reduced. As a result, the electrical connection between the chip and the circuit substrate, for example, a long bump (Bump) or a solder ball, is easily broken in a temperature cycle test and a use process of the product. Consequently, the product fails.

In another conventional technical solution for resolving the cracking of the solder mask, the solder mask is replaced with an Ajinomoto build-up film (Ajinomoto Build-up Film, ABF) to enhance material strength, and a copper boss is further added to resolve an undercutting problem caused by an intermetallic compound (Intermetallic Compound, IMC) formed by a copper pad and solder (such as Sn). In this manner, a problem that a solder resist material cracks from a weak point at a corner of an edge of the pad can be resolved.

However, in this solution, on one hand, a technological process is complex. As a result, high manufacturing costs are caused. On the other hand, this solution may also cause a problem such as pad floating and ABF delamination. As a result, quality and reliability of a product is seriously affected.

In still another solution for resolving the cracking of the solder mask, the solder mask uses a non-solder mask defined (Non-Solder Mask Defined, NSMD) design. The NSMD is in contrast to the SMD mentioned above. The NSMD is to design a pad smaller than an opening of the solder mask. In other words, all parts of the pad including an edge are exposed to the opening of the solder mask. A problem of undercutting of the solder mask can be avoided by using the NSMD, so that the problem of cracking of the solder mask can be resolved.

However, because bonding between the pad and a circuit substrate material (for example, ABF) at the bottom is poor, and the edge of the pad is not covered by the solder mask, when the edge of the pad is pulled by stress, a problem such as the pad falling off from a circuit substrate may occur. As a result, performance and reliability of a product is affected, and consequently, the product may finally fail.

In view of the foregoing problems and another potential problem in conventional solutions, an embodiment of the present disclosure provides a circuit substrate 100 for carrying an electronic device. The circuit substrate 100 mentioned in this specification may refer to an integrated circuit (Integrated Circuit, IC) carrier board or a package carrier board. The IC carrier board is mainly used as an IC carrier, and provides signal interconnection, a heat dissipation channel, and chip protection between a chip and a printed circuit board. The IC carrier board is a key component in a package. Basic materials of the IC carrier board include copper foil, a resin circuit substrate, a dry film (solid photoresist), a wet film (liquid photoresist), a metal material (copper, nickel, and gold salt), and the like. A manufacturing process of the IC carrier board is similar to that of the printed circuit board. However, the IC carrier board has higher wiring density, line width, line spacing, inter-layer alignment precision, and material reliability than the printed circuit board.

The IC carrier board is mainly classified into three types: a hard circuit substrate, a flexible thin film circuit substrate and a co-fired ceramic circuit substrate. The IC carrier board usually uses a laminated structure, in other words, is formed by stacking conductive and nonconductive materials of different thicknesses. Based on a material thereof, the hard IC carrier board may be classified into an Ajinomoto build-up film (Ajinomoto Build-up Film, ABF) carrier board, a bismaleimide triazine (Bismaleimide Triazine, BT) resin carrier board, and a molded substrate (Molded Interconnect Substrate, MIS).

Certainly, it should be understood that the circuit substrate 100 mentioned in this specification may not only refer to the IC carrier board for packaging, but also refer to a printed circuit board (Printed Circuit Board, PCB) for carrying a package body. Correspondingly, in addition to a semiconductor chip, an electronic device 201 mentioned in this specification may further include a semiconductor chip package body and/or a circuit adapter board. The following describes embodiments of the present disclosure mainly by using an example in which the circuit substrate 100 is an IC carrier board and the electronic device 201 is a semiconductor chip. This is similar to a case in which the circuit substrate 100 is a printed circuit board and the electronic device 201 includes a chip package body and/or a circuit adapter board, and details are not described below separately.

The circuit substrate 100 in this specification may be a single-sided board, a double-sided board, or a multilayer board. The single-board refers to a most basic structure of the circuit substrate 100, where the electronic devices 201 are centralized on one side, and conducting wires are centralized on the other side. The double-sided board is a circuit board that includes a top layer and a bottom layer and that is coated with copper on both sides. Both the sides can be wired and soldered, and an insulation layer is in the middle. The multilayer board uses a wiring board including more single-sided boards or double-sided boards. A circuit board that uses one double-sided board as an inner layer and two single-sided boards as an outer layer or two double-sided boards as an inner layer and two single-sided boards as an outer layer is used. The multilayer board is a circuit board formed by alternately stacking a plurality of single-sided boards and/or double-sided boards together by aligning conductive patterns and by using an insulation bonding material. A largest difference between the multilayer board and both the single-sided board and double-sided board is that an internal power source layer (which is referred to as an internal electrical layer) and a ground layer are added. A power source and a ground cable network are mainly wired on the power layer. However, wiring of the multilayer board is mainly based on a top layer and a bottom layer, and is supplemented by an intermediate wiring layer. Therefore, a design method of the multilayer board is basically the same as that of the double-sided board. A key thereof is how to optimize the wiring of the internal electrical layer, so that wiring of the circuit board is more reasonable and electromagnetic compatibility is better.

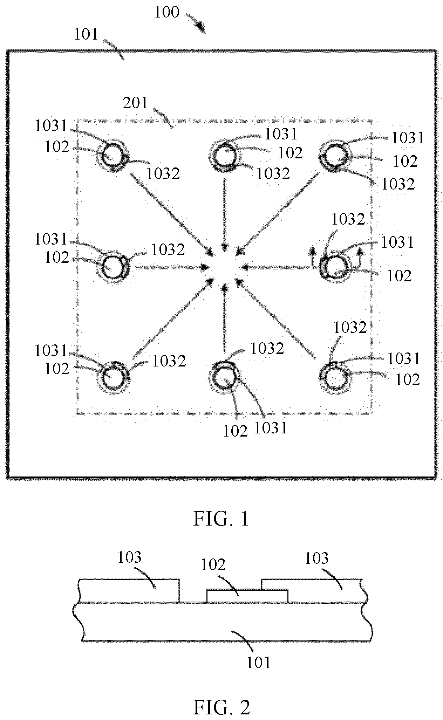

FIG. 1 is a schematic top view of a circuit substrate 100 according to an embodiment of the present invention, where an electronic device 201 is shown by using a dash-dot line box. As shown in FIG. 1, the circuit substrate 100 for carrying the electronic device 201 mainly includes a body 101, a plurality of pads 102, and a solder mask 103. It should be understood that, a quantity and positions of components such as the pad 102 shown in FIG. 1 are merely intended to show a simplified schematic structure used in an inventive idea of the present disclosure. The pad 102 of the circuit substrate 100 to which the inventive idea of the present disclosure can be applied may have any suitable arrangement manner and quantity corresponding to a pin 2011 or a bump of a chip. The body 101 may be made of any one of an ABF material, a BT resin material, and an MIS material that are mentioned above. The following describes embodiments of the present disclosure mainly by using the body 101 made of the ABF material as an example. It should be understood that this is similar to that of a body 101 made of another type of material, and details are not described below separately.

The electronic device 201 is carried on a surface that is of the body 101 and that has a plurality of pads 102, and the pin 2011 of the electronic device 201 is electrically connected to a corresponding pad 102. A flip chip (Flip Chip, FC) technology may be used for the electrical connection between the electronic device 201 and the pad 102. The flip chip technology is an electrical connection manner in which a wafer is mounted to a package carrier. A conductive "bump" (which is also referred to as the pin 2011 below) directly disposed on a surface of the chip is used for interconnection between a flip-packaged chip and the circuit substrate 100. Then, the chip including the pin 2011 or the bump is "flipped over", where a front side is placed downward, and the pin 2011 or the bump is directly connected to the pad 102 of the circuit substrate 100. The pin 2011 of the chip and the pad 102 may be connected by using solder such as eutectic tin/lead or lead-free solder. The chip is mounted to the circuit substrate 100 by using a solder reflow process. After the chip is mounted, an underfill material is used to fill between the chip and the circuit substrate 100. The underfill material may be a material such as an epoxy resin that is specially engineered and that surrounds a solder bump. The underfill material controls solder point stress generated by a thermal expansion difference between a semiconductor chip and the circuit substrate 100. After curing, the underfill material absorbs the stress, reduces strain of the solder bump, and greatly prolongs a life of a finished product package. Steps of chip mounting and underfill are basis of a flip chip interconnection.

It should be understood that the foregoing embodiment of mounting the chip on the circuit substrate 100 by using the flip chip technology is merely an example. The inventive idea of the present disclosure may be further applied to any other suitable packaging or electrical connection manner in which the solder mask 103 is used. For example, in some embodiments, the inventive idea of the present disclosure may be further applied to a ball grid array (Ball Grid Array, BGA) packaging technology. In the BGA packaging technology, a solder ball array is manufactured at the bottom of the package body circuit substrate 100 as an I/O end of a circuit to interconnect with a printed circuit board. A device packaged by using this technology is a surface mounting device. The following mainly describes the inventive idea of the present disclosure by using the flip chip technology as an example. This is similar to that of another type of packaging manner or electrical connection manner, and details are not described below.

The solder mask 103 covers the surface on which the electronic device 201 is to be carried and at least a part of an edge of the pad 102. In other words, the solder mask 103 in this embodiment of the present disclosure mainly uses a solder mask defined (Solder Mask Defined, SMD) design. A plurality of openings 1031 of the solder mask 103 correspond to positions of the pads 102 to expose the pads 102, so that the pad 102 can be electrically connected to the pin 2011 of the electronic device 201.

Different from a conventional SMD technical solution, as shown in FIG. 1, the opening 1031 of the solder mask 103 in this embodiment of the present disclosure includes at least one notch part 1032. The notch part 1032 refers to a part that is in the opening 1031 and whose radius is greater than that of a remaining part. The notch part 1032 is formed to have a predetermined angle A relative to a center of the opening 1031, to expose a part that is of the edge of the pad 102 and that is within the predetermined angle A. In other words, for the notch part 1032, the solder mask uses a non-solder mask defined (Non-Solder Mask Defined, NSMD) design.

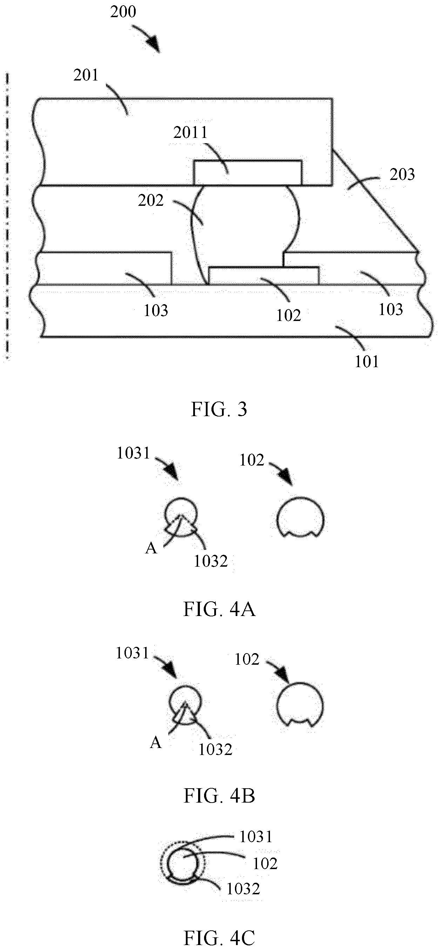

FIG. 2 is a schematic side view of an A-A cross section in FIG. 1, and FIG. 3 is a schematic side view of a package body that has been formed by the electronic device 201 and the circuit substrate 100. With reference to FIG. 2 and FIG. 3, it may be found that, the notch part 1032 is disposed at a position at which the solder mask 103 easily cracks, so that when solder is applied, the solder mask 103 does not undercut a weak point, and the solder directly covers the edge of a pad 102 and be combined with the body 101. In addition, an underfill material enters between the solder and the solder mask 103 to isolate the solder from the solder mask 103. In this case, even if a part of the solder mask 103 cracks, the solder does not enter through a crack, so that there is no risk that the electronic device 201 fails. Therefore, reliability of the package body is improved.

In addition, because the notch part 1032 is used to expose the edge of the pad 102, a risk that the solder enters from the crack of the solder mask 103 to enable the electronic device 201 to fail is eliminated. Therefore, the underfill material does not need to use a soft material to prevent the solder mask 103 from cracking. In other words, the underfill material may be made of any suitable material, so that an electrical connection between the pin 2011 of the chip and the pad 102 is not affected, and the reliability of the package body is further improved.

In addition, a part (most) of the solder mask 103 that uses the inventive idea of the present disclosure remains an SMD design. For the notch part 1032 (where the part uses an NSMD) that exposes the edge of the pad 102, the part with the SMD design can still provide security for a connection between the edge of the pad 102 and the body 101, to effectively prevent the pad 102 from falling off.

In addition to the benefits mentioned above, benefits of the circuit substrate 100 in this embodiment of the present disclosure can be implemented by using only small adjustment on an existing circuit substrate 100, in other words, many problems in the conventional solutions can be resolved and the foregoing benefits can be implemented by adjusting only a design of the opening 1031 (Solder Resist Opening, SRO) of the solder mask 103. Therefore, no additional cost is increased. In addition, the notch part 1032 may further implement an effect that an original soldering area remains unchanged with reference to partial indentation of the pad 102, so that stability of the package body can be improved without changing electrical performance of the package body.

In the claimed embodiment the pad 102 is partially indented. FIG. 4A, FIG. 4B, and FIG. 4C are respectively partial top views of an opening 1031 of a solder mask 103 and a pad 102 involved in three different embodiments. The opening 1031 and the pad 102 shown in FIG. 4A use basically the same structures as the opening 1031 and the pad 102 in the circuit substrate 100 shown in FIG. 2 and FIG. 3. It may be learned that, in some embodiments, an angle of a notch part 1032 of the opening 1031 relative to a center of the opening 1031 may be approximately 90°.

It should be understood that the angle of the notch part 1032 being approximately 90° is merely an example. Based on severity of cracking of the solder mask 103, any other suitable angle is alternatively possible. For example, FIG. 4B shows a notch part 1032 with a small angle. The small angle may be any suitable angle from 30° to 90°. The pad 102 can be prevented, by using the notch part 1032 with the small angle, from falling off, and reliability is further improved. Certainly, it should be understood that the angle of the notch part 1032 relative to the center of the opening 1031 may alternatively be greater than 90°, for example, any suitable angle in a range from 90° to 130°. The notch part 1032 with a large range may include an embodiment in which the solder mask 103 cracks seriously, to effectively avoid an impact of the cracking of the solder mask 103 on reliability of a package body.

That the pad 102 uses an indentation structure mentioned above means that a part that is of the pad 102 and that corresponds to the notch part 1032 is cut away from the radial outside, so that a radius of the part is reduced. In some embodiments, to implement that an original soldering area is unchanged, a radius of the part that is of the pad 102 and that corresponds to the notch part 1032 is equal to a radius of another part of the opening 1031 except the notch part 1032, as shown in FIG. 1. In this manner, in comparison with the solder mask 103 in which the solder mask is manufactured by using an SMD design (in other words, the solder mask 103 covers an entire edge of the pad 102 and a radius of a part of the pad 102 exposed to the opening 1031 is a radius of the opening 1031), the soldering area between the solder and the pad 102 basically remain unchanged, so that stability of the package body can be improved without changing electrical performance of the package body.

It is alternatively possible to use any other suitable indentation radius for the pad 102. For example, in some embodiments, as shown in FIG. 4C, the radius of the part that is of the pad 102 and that corresponds to the notch part 1032 may alternatively be indented inward to be greater than the radius of another part of the opening 1031 except the notch part 1032, so that the soldering area is effectively increased, and electrical performance is improved. In some further alternative embodiments, the pad 102 may alternatively not be indented. In other words, a size and a shape of the pad 102 remain unchanged, and an original circle shape remains unchanged. A radius of the notch part 1032 is set, to be greater than a radius of the pad 102, so that an edge of the pad 102 is exposed.

Another feature of the notch part 1032 in this embodiment of the present disclosure is that the notch part 1032 of at least a part of a plurality of openings 1031 is arranged toward a predetermined point. The arrangement toward the predetermined point means that a connection line between the center of the opening 1031 in which the notch part 1032 is located and the predetermined point passes through the notch part 1032. This arrangement manner of the notch part 1032 enables the solder mask 103 to flexibly cope with a plurality of cases of the cracking of the solder mask 103 due to factors such as thermal expansion and contraction deformation. For example, in some embodiments, a notch part 1032 of a part (which is referred to as a first part below) of the opening 1031 may be arranged toward one first predetermined point, and a notch part 1032 of another part (which is referred to as a second part below) of the opening 1031 may be arranged toward the other second predetermined point. Depending on different cases of the cracking of the solder mask 103 that needs to be coped with, the first part or the second part of the opening 1031 mentioned above may refer to an opening of a plurality of rows and columns, or may refer to a plurality of openings including a single row or a single column.

Certainly, it should be understood that notch parts of at least a part of openings in the plurality of openings 1031 mentioned above further include a case in which notch parts of all the openings 1031 are arranged toward one predetermined point. In this case, the predetermined point may be, for example, a geometric center of the carried electronic device 201. The geometric center is the most central position of an object with symmetry. For a rectangular chip that is usually used, a geometric center of the rectangular chip is an intersection point of diagonal lines of the chip. It is found, through researching, that the cracking of the solder mask 103 is largely caused by stress on the solder mask 103 caused by deformation of the electronic device 201 due to heat in a packaging process. Statistics show that, for some square electronic devices 201, a risk of cracking is the highest on an edge that is of the opening 1031 of the solder mask 103 and that is in a direction of the geometric center of the electronic device 201. This is due to the largest deformation of the electronic device 201 in a direction of the geometric center after being heated in the packaging process. Therefore, in some embodiments, the notch part 1032 may be disposed from a direction of the geometric center of the opening 1031 to the electronic device 201. That the notch part 1032 is in a direction of the geometric center means that a connection line between a center of the opening 1031 in which the notch part 1032 is located and the geometric center of the electronic device 201 passes through the notch part 1032.

In this manner, in comparison with a case in which there is no notch part or a notch part is disposed in another direction, when the notch part 1032 is distributed in a direction of the geometric center that is of the opening 1031 and that faces the electronic device 201, a case in which the solder mask 103 cracks due to thermal stress caused by thermal expansion and contraction can be effectively avoided, so that a risk that the electronic device 201 fails is eliminated. Therefore, the reliability of the package body is improved. In some embodiments, the connection line may be a symmetric line of the notch part 1032, in other words, a predetermined angle A is equally divided. In some alternative embodiments, the connection line may alternatively pass through the notch part 1032 at any angle within a range of the predetermined angle A of the notch part 1032. The following describes embodiments of the present disclosure mainly by using an example in which a connection line between the center of the opening 1031 and the geometric center of the electronic device 201 passes through the notch part 1032 in a manner of a symmetrical line. Other cases are similar, and details are not described below.

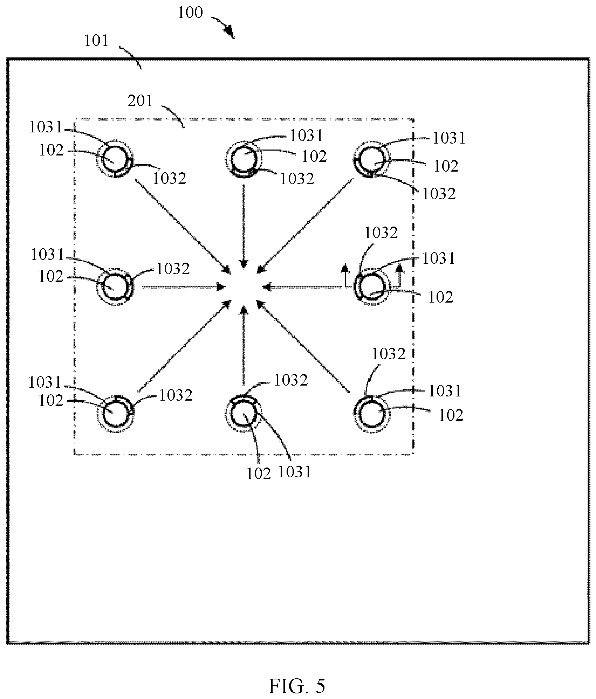

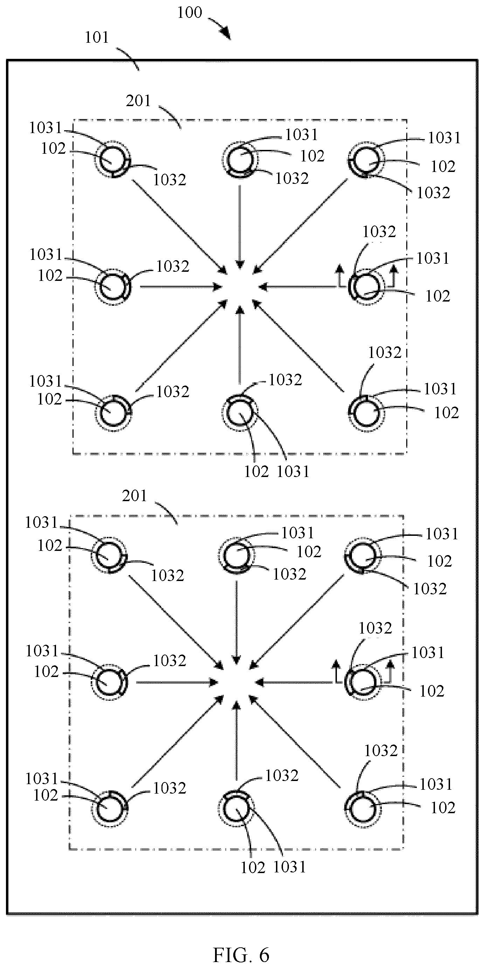

FIG. 1, FIG. 5, and FIG. 6 respectively show several different types of structures of a circuit substrate 100. A difference between structures of the circuit substrates 100 mainly lies in a position and a quantity of electronic devices 201 on the circuit substrate 100. For example, FIG. 1 shows that the electronic device 201 is basically located at a center of the circuit substrate 100. FIG. 5 shows a position of the electronic device 201 on a side of the circuit substrate 100. FIG. 6 shows that the circuit substrate 100 can carry two electronic devices 201. It may be learned from FIG. 1, FIG. 5, and FIG. 6 that, regardless of the position and the quantity of electronic devices 201, a notch part 1032 of an opening 1031 is in a direction of a geometric center of a corresponding electronic device 201. In this manner, a problem that the solder mask 103 cracks in a centripetal direction can be effectively resolved. Therefore, performance of a package body is improved.

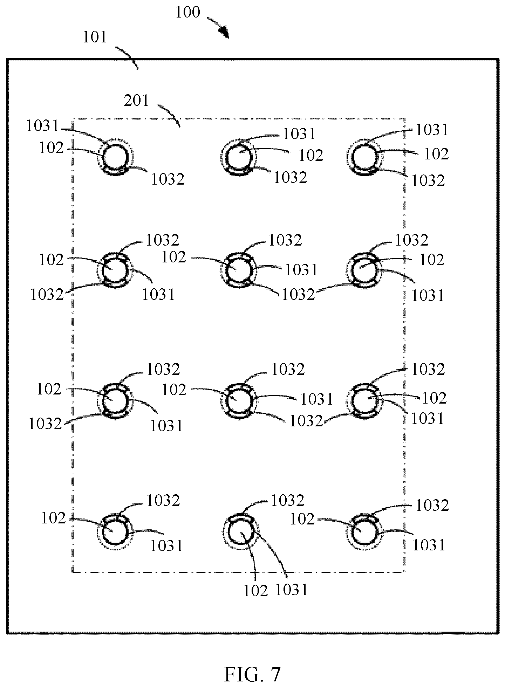

It should be understood that the foregoing embodiments in which the notch part 1032 is disposed at a centripetal position are merely examples. Any other suitable arrangement position or structure is alternatively possible. For example, in some alternative embodiments, for some electronic devices 201 with special structures, a probability that deformation occurs along a length direction may be highest during being heated. In this case, as shown in FIG. 7, it is alternatively possible that the notch part 1032 is disposed in a length direction of the opening 1031. In this case, a part of notch parts 1032 of the openings 1031 in each column are arranged toward a predetermined point.

In addition, FIG. 7 further shows that, for the opening 1031 of the solder mask 103 in the middle, because cracking may occur on both sides, notch parts 1032 are disposed at two corresponding positions along the length direction of the opening 1031, so that an impact caused by cracking of the solder mask 103 on a structure of the package body is effectively avoided. Therefore, the performance of the package body is improved.In other words, for each opening 1031, the notch part 1032 may be disposed at two or more positions based on a requirement.

It should be further understood that the foregoing embodiments related to disposition of the notch part 1032 and a direction in which the electronic device 201 undergoes largest deformation due to thermal expansion and contraction are merely examples. In addition to a stress factor caused by thermal expansion and contraction, cracking of the solder mask 103 may alternatively be related to other factors, for example, a structure and thickness of each layer in laminated arrangement of a body 101. For example, in some alternative embodiments, the cracking of the solder mask 103 may alternatively occur at a position at which a buried opening is disposed on the body 101. In this case, the notch part 1032 may alternatively be correspondingly disposed at a position at which a buried hole is disposed on the body 101 or at a position close to the buried opening, so that an impact caused by the cracking of the solder mask 103 on the structure of the package body is effectively avoided. Therefore, the performance of the package body is improved.

In an embodiment of the present disclosure, a circuit assembly such as a semiconductor package body is further provided. The circuit assembly includes an electronic device 201 such as a semiconductor chip and the circuit substrate 100 described above. Reliability of the circuit assembly can be improved by using the circuit substrate 100 in this embodiment of the present disclosure. The circuit substrate 100 may be mounted or coupled to the circuit substrate 100 by using a flip chip technology. In addition, as mentioned above, by using the circuit substrate 100 in this embodiment of the present disclosure, any suitable underfill material may be used, and a soft underfill material does not need to be used to prevent a solder mask 103 from cracking. For example, in some embodiments, the underfill material may be an underfill adhesive, a solid-state molded material, or a combination of the underfill adhesive and the solid-state molded material. In this manner, a suitable underfill material can be used without weakening an electrical connection between a pad 102 and a pin 2011 of the electronic device 201, to improve flexibility and reliability of manufacturing the package body.

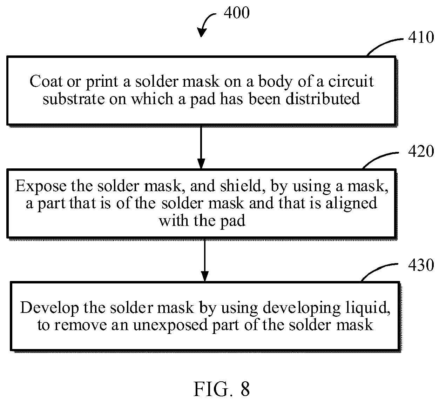

In an embodiment of the present disclosure, a method 400 for manufacturing a circuit substrate 100 for carrying an electronic device 201 is further provided. FIG. 8 is a schematic flowchart of the method. As shown in FIG. 8, in 410, a solder mask 103 is disposed on a body 101 that is of the circuit substrate 100 and on which a pad 102 has been distributed. The solder mask 103 may be applied to the body 101 in a manner of coating or screen printing. In 420, exposure is performed on the solder mask 103, for example, by using an ultraviolet ray. During exposure, a part that is of the solder mask 103 and is aligned with the pad 102 is shielded by using a mask, to prevent these parts from being exposed. The mask may include a mask body and at least one radial protruding part that protrudes from the mask body. Shapes of the shield body and the radial protruding part correspond to the shapes of the opening 1031 and the notch part 1032 mentioned above, to ensure that a part that is of the solder mask 103 and on which the opening 1031 and the notch part 1032 are to be formed is not exposed. The radial protruding part of at least a part of the mask is arranged toward a predetermined point, so that the notch part 1032 of the at least a part of the formed opening 1031 is arranged toward the predetermined point.

In step 430, the solder mask 103 is developed by using developing liquid, to remove an unexposed part of the solder mask 103. The unexposed part formed by using the mask body and the radial protruding part includes the opening 1031 including at least one notch part 1032 mentioned above, and the notch part 1032 corresponds to a position of the radial protruding part. In this way, the circuit substrate 100 including the solder mask 103 mentioned above is formed.

In some embodiments, the foregoing method further includes: removing an edge that is of the pad 102 and that is to be exposed to the notch part 1032, to enable a radius that is of the pad 102 and that corresponds to the notch part 1032 to be equal to a radius of a remaining part of the opening 1031 other than the notch part 1032. This step may be completed before the pad 102 is applied to the body 101. In this manner, a soldering area between solder and the pad 102 can basically remain unchanged, so that stability of a package body can be improved without changing electrical performance of the package body.

In an embodiment of the present disclosure, electronic equipment is further provided. The electronic equipment includes the circuit substrate 100 described above and an electronic device 200 that is carried on a surface of a body of the circuit substrate 100. Certainly, in some embodiments, the electronic equipment may further include components such as a housing. By using the circuit substrate 100, various adverse effects and problems caused by cracking of the solder mask can be effectively reduced, and reliability of the electronic equipment is improved.

Although a subject has been described in language specific to a structural feature and/or a method action, it should be understood that the subject defined in the appended claims is not limited to the specific feature or the action described above. Instead, the specific feature and the action described above are disclosed as example forms of implementing the claims.

## Claims

1. A circuit substrate, comprising:
a body (101), comprising a surface for carrying an electronic device (201);
a plurality of pads (102), distributed on the surface; and
a solder mask (103), distributed to cover the surface and at least a part of an edge of each pad (102), and comprising a plurality of openings (1031), wherein the plurality of openings (1031) are suitable for exposing the plurality of pads (102) to allow each pad (102) to be electrically connected to a pin (2011) of the electronic device (201), wherein
each of the plurality of openings (1031) comprises at least one notch part (1032), the notch part (1032) is formed to have a predetermined angle (A) relative to a center of the opening (1031) to expose a part that is of the edge of each pad (102) and that is within the predetermined angle (A), and the notch part (1032) of at least a part of the plurality of openings (1031) is arranged toward a predetermined point;
**characterised in that** each pad of the plurality of pads is partially indented such that an area of each pad exposed to the respective notch part is reduced.

2. The circuit substrate according to claim 1, such that, when an electronic device is carried on the surface, the notch part (1032) is distributed on the opening (1031) in a direction of a geometric center of the electronic device (201).

3. The circuit substrate according to claim 1, wherein each pad (102) is formed to enable a radius, that is of the pad (102) and that corresponds to the notch part (1032), to be greater than or equal to a radius of another part of the opening (1031) other than the notch part (1032).

4. The circuit substrate according to claim 1, wherein the electronic device (201) comprises a semiconductor chip, a semiconductor package body, or an adapter board.

5. A circuit assembly, comprising:
an electronic device (201); and
the circuit substrate (100) according to any one of claims 1 to 4.

6. The circuit assembly according to claim 5, wherein the electronic device (201) is coupled to the circuit substrate (100) by using a flip chip technology.

7. The circuit assembly according to claim 5, further comprising at least one of an underfill adhesive and a solid-state molding material that are filled between the electronic device (201) and the circuit substrate (100).

8. A method for manufacturing a circuit substrate (100) for carrying an electronic device (201), wherein the method comprises:
coating or printing a solder mask (103) on a body (101) of the circuit substrate (100) on which a plurality of pads (102) has been distributed;
exposing the solder mask (103), and shielding, by using a mask, a part that is of the solder mask (103) and that is aligned with each pad (102) to prevent the part from being exposed, wherein the mask comprises a mask body and at least one radial protruding part that protrudes from the mask body, the radial protruding part is distributed in a predetermined angle range relative to a center of the mask body, and the radial protruding part of at least a part of the mask is arranged toward a predetermined point; and
developing the solder mask (103) by using developing liquid, to remove an unexposed part of the solder mask (103), wherein the unexposed part comprises an opening (1031) comprising a notch part (1032), and the notch part (1032) corresponds to the radial protruding part;
the method **characterised in that** it further comprises:
removing an edge that is of the pad (102) and that is to be exposed to the notch part (1032), to enable a radius, that is of the pad (102) and that corresponds to the notch part (1032) to be equal to a radius of a remaining part of the opening (1031) other than the notch part (1032),
wherein this step is completed before the pad (102) is applied to the body (101).

9. Electronic equipment, comprising:
the circuit substrate (100) according to any one of claims 1 to 4; and
an electronic device (201), carried on the surface of the body (101) of the circuit substrate (100).

## Patentansprüche

1. Schaltungssubstrat, umfassend:
einen Körper (101), umfassend eine Oberfläche zum Tragen einer elektronischen Vorrichtung (201);
eine Vielzahl von Pads (102), die auf der Oberfläche verteilt sind; und
eine Lötmaske (103), die dazu verteilt ist, die Oberfläche und mindestens einen Teil einer Kante jedes Pads (102) zu bedecken, und umfassend eine Vielzahl von Öffnungen (1031), wobei die Vielzahl von Öffnungen (1031) zum Freilegen der Vielzahl von Pads (102) geeignet ist, um es jedem Pad (102) zu ermöglichen, elektrisch mit einem Stift (2011) der elektronischen Vorrichtung (201) verbunden zu sein, wobei
jede der Vielzahl von Öffnungen (1031) mindestens einen Kerbteil (1032) umfasst, wobei der Kerbteil (1032) dazu gebildet ist, einen vorbestimmten Winkel (A) relativ zu einer Mitte der Öffnung (1031) aufzuweisen, um einen Teil der Kante jedes Pads (102), der innerhalb des vorbestimmten Winkels (A) liegt, freizulegen, und wobei der Kerbteil (1032) von mindestens einem Teil der Vielzahl von Öffnungen (1031) zu einem vorbestimmten Punkt hin angeordnet ist;
**dadurch gekennzeichnet, dass** jedes Pad der Vielzahl von Pads teilweise eingedellt ist, sodass eine Fläche jedes Pads, die dem jeweiligen Kerbteil gegenüber freigelegt ist, reduziert ist.

2. Schaltungssubstrat nach Anspruch 1, sodass, wenn eine elektronische Vorrichtung auf der Oberfläche getragen wird, der Kerbteil (1032) in einer Richtung einer geometrischen Mitte der elektronischen Vorrichtung (201) auf der Öffnung (1031) verteilt ist.

3. Schaltungssubstrat nach Anspruch 1, wobei jedes Pad (102) dazu gebildet ist, es einem Radius des Pads (102), der dem Kerbteil (1032) entspricht, zu ermöglichen, größer als oder gleich einem Radius eines anderen Teils der Öffnung (1031), der nicht der Kerbteil (1032) ist, zu sein.

4. Schaltungssubstrat nach Anspruch 1, wobei die elektronische Vorrichtung (201) einen Halbleiterchip, einen Halbleitergehäusekörper oder eine Adapterplatine umfasst.

5. Schaltungsanordnung, umfassend:
eine elektronische Vorrichtung (201); und
das Schaltungssubstrat (100) nach einem der Ansprüche 1 bis 4.

6. Schaltungsanordnung nach Anspruch 5, wobei die elektronische Vorrichtung (201) unter Verwendung einer Flip-Chip-Technologie mit dem Schaltungssubstrat (100) gekoppelt ist.

7. Schaltungsanordnung nach Anspruch 5, ferner umfassend mindestens eines von einem Füllmaterialklebstoff und einem Festkörperformmaterial, die zwischen die elektronische Vorrichtung (201) und das Schaltungssubstrat (100) gefüllt sind.

8. Verfahren zum Herstellen eines Schaltungssubstrats (100) zum Tragen einer elektronischen Vorrichtung (201), wobei das Verfahren Folgendes umfasst:
Beschichten oder Aufdrucken einer Lötmaske (103) auf einen Körper (101) des Schaltungssubstrats (100), auf dem eine Vielzahl von Pads (102) verteilt worden ist;
Freilegen der Lötmaske (103) und Abschirmen, unter Verwendung einer Maske, eines Teils der Lötmaske (103), der mit jedem Pad (102) ausgerichtet ist, um zu verhindern, dass der Teil freigelegt wird, wobei die Maske einen Maskenkörper und mindestens einen radial vorstehenden Teil umfasst, der von dem Maskenkörper vorsteht, wobei der radial vorstehende Teil in einem vorbestimmten Winkelbereich relativ zu einer Mitte des Maskenkörpers verteilt ist und der radial vorstehende Teil von mindestens einem Teil der Maske zu einem vorbestimmten Punkt hin angeordnet ist; und
Entwickeln der Lötmaske (103) unter Verwendung von Entwicklerflüssigkeit, um einen nicht freigelegten Teil der Lötmaske (103) zu entfernen, wobei der nicht freigelegte Teil eine Öffnung (1031) umfasst, die einen Kerbteil (1032) umfasst, und der Kerbteil (1032) dem radial vorstehenden Teil entspricht;
wobei das Verfahren **dadurch gekennzeichnet ist, dass** es ferner Folgendes umfasst:
Entfernen einer Kante des Pads (102), die dem Kerbteil (1032) gegenüber freizulegen ist, um es einem Radius des Pads (102),
der dem Kerbteil (1032) entspricht, zu ermöglichen, gleich einem Radius eines verbleibenden Teils der Öffnung (1031), der nicht der Kerbteil (1032) ist, zu sein,
wobei dieser Schritt abgeschlossen wird, bevor das Pad (102) auf den Körper (101) aufgebracht wird.

9. Elektronische Ausrüstung, umfassend:
das Schaltungssubstrat (100) nach einem der Ansprüche 1 bis 4; und
eine elektronische Vorrichtung (201), die auf der Oberfläche des Körpers (101) des Schaltungssubstrats (100) getragen wird.

## Revendications

1. Substrat de circuit, comprenant :
un corps (101), comprenant une surface destinée à supporter un dispositif électronique (201) ;
une pluralité de coussinets (102), répartis sur la surface ; et un masque de soudure (103), réparti de manière à recouvrir la surface et au moins une partie d'un bord de chaque coussinet (102), et comprenant une pluralité d'ouvertures (1031), dans lequel la pluralité d'ouvertures (1031) est adaptée pour exposer la pluralité de coussinets (102) afin de permettre à chaque coussinet (102) d'être connecté électriquement à une broche (2011) du dispositif électronique (201), dans lequel chacune de la pluralité d'ouvertures (1031) comprend au moins une partie d'encoche (1032), la partie d'encoche (1032) est formée pour avoir un angle prédéterminé (A) par rapport à un centre de l'ouverture (1031) afin d'exposer une partie qui est du bord de chaque coussinet (102) et qui se trouve dans l'angle prédéterminé (A), et la partie d'encoche (1032) d'au moins une partie de la pluralité d'ouvertures (1031) est disposée vers un point prédéterminé ;
**caractérisé en ce que** chaque coussinet de la pluralité de coussinets est partiellement en retrait de sorte qu'une surface de chaque coussinet exposée à la partie d'encoche respective est réduite.

2. Substrat de circuit selon la revendication 1, de sorte que, lorsqu'un dispositif électronique est porté sur la surface, la partie d'encoche (1032) est répartie sur l'ouverture (1031) dans une direction du centre géométrique du dispositif électronique (201).

3. Substrat de circuit selon la revendication 1, dans lequel chaque coussinet (102) est formé pour permettre à un rayon, qui est celui du coussinet (102) et qui correspond à la partie d'encoche (1032), d'être supérieur ou égal à un rayon d'une autre partie de l'ouverture (1031) autre que la partie d'encoche (1032).

4. Substrat de circuit selon la revendication 1, dans lequel le dispositif électronique (201) comprend une puce semiconductrice, un corps d'emballage semi-conducteur ou une carte d'adaptation.

5. Ensemble de circuits, comprenant :
un dispositif électronique (201) ; et
le substrat de circuit (100) selon l'une quelconque des revendications 1 à 4.

6. Ensemble de circuits selon la revendication 5, dans lequel le dispositif électronique (201) est couplé au substrat de circuit (100) à l'aide d'une technologie puce retournée.

7. Ensemble de circuits selon la revendication 5, comprenant en outre au moins l'un d'un adhésif de sous-remplissage et un matériau de moulage à l'état solide qui sont insérés entre le dispositif électronique (201) et le substrat de circuit (100).

8. Procédé de fabrication d'un substrat de circuit (100) destiné à supporter un dispositif électronique (201), dans lequel le procédé comprend :
le revêtement ou l'impression d'un masque de soudure (103) sur un corps (101) du substrat de circuit (100) sur lequel une pluralité de coussinets (102) a été distribuée ;
l'exposition du masque de soudure (103) et la protection, à l'aide d'un masque, d'une partie qui appartient au masque de soudure (103) et qui est alignée avec chaque coussinet (102) afin d'empêcher l'exposition de la partie, dans lequel le masque comprend un corps du masque et au moins une partie saillante radiale qui fait saillie du corps du masque, la partie saillante radiale est répartie dans une plage angulaire prédéterminée par rapport au centre du corps du masque, et la partie saillante radiale d'au moins une partie du masque est disposée vers un point prédéterminé ; et
le développement du masque de soudure (103) à l'aide d'un liquide de développement, pour enlever une partie non exposée du masque de soudure (103), dans lequel la partie non exposée comprend une ouverture (1031) comprenant une partie d'encoche (1032), et la partie d'encoche (1032) correspond à la partie saillante radiale ;
le procédé étant **caractérisé en ce qu'**il comprend en outre :
la suppression d'un bord qui appartient au coussinet (102) et
qui doit être exposé à la partie d'encoche (1032), afin de permettre à un rayon, qui appartient au coussinet (102) et qui correspond à la partie d'encoche (1032), d'être égal à un rayon d'une partie restante de l'ouverture (1031) autre que la partie d'encoche (1032),
dans lequel cette étape est réalisée avant que le coussinet (102) ne soit appliqué sur le corps (101).

9. Équipement électronique, comprenant :
le substrat de circuit (100) selon l'une quelconque des revendications 1 à 4 ; et
un dispositif électronique (201), porté sur la surface du corps (101) du substrat de circuit (100).
